# FASCICULE DE BREVET EUROPEEN

(11) **EP 1 330 836 B1**
(45) Date de publication et mention de la délivrance du brevet: **11.01.2006**
(21) Numéro de dépôt: 01983662.6
(22) Date de dépôt: 30.10.2001
(51) Int. Cl.: H01L 21/20, H01L 21/329, H01L 29/872

(54) **PROCEDE DE REALISATION D'UNE DIODE SCHOTTKY DANS DU CARBURE DE SILICIUM**
VERFAHREN ZUR HERSTELLUNG VON EINER SCHOTTKY DIODE IN SILIZIUMKARBID
METHOD FOR PRODUCING A SCHOTTKY DIODE IN SILICON CARBIDE

(30) Priorité: 31.10.2000 FR 0014012
(43) Date de publication de la demande: 30.07.2003
(73) Titulaire: STMicroelectronics S.A., 92120 Montrouge (FR)
(72) Inventeur: COLLARD, Emmanuel, F-37100 Tours (FR)
(74) Mandataire: de Beaumont, Michel
(86) Numéro de dépôt international: PCT/FR2001/003379
(87) Numéro de publication internationale: WO 2002/037546

(56) Documents cités:
- EP-A- 0 380 340
- EP-A- 0 869 558
- US-A- 3 575 731
- US-A- 4 636 269
- US-A- 5 917 228
- US-A- 6 091 108
- PATENT ABSTRACTS OF JAPAN vol. 002, no. 051 (E-026), 12 avril 1978 (1978-04-12) -& JP 53 014579 A (HITACHI LTD), 9 février 1978 (1978-02-09)

## Description

La présente invention concerne la réalisation d'une diode Schottky dans du carbure de silicium.

Dans le domaine des composants semiconducteurs, le matériau principalement utilisé à l'heure actuelle est le silicium. Pour la tenue de tensions très élevées, le carbure de silicium est a priori préférable car le carbure de silicium peut supporter des tensions par unité d'épaisseur environ 10 fois plus élevées que le silicium.

Toutefois, dans l'état actuel des technologies, les filières couramment utilisées pour la réalisation de composants à base de silicium ne sont pas transposables pour la réalisation de composants à base de carbure de silicium (SiC). En particulier, il n'est actuellement pas possible en pratique de réaliser des implantations et diffusions de dopants de type P dans du carbure de silicium dopé de type N, en notant que le dopant de type P couramment utilisé pour le carbure de silicium est de l'aluminium et le dopant de type N est de l'azote. En effet, un recuit pour diffusion d'une implantation d'un dopant de type P nécessiterait des températures de l'ordre de 1700°C, ce qui pose des problèmes technologiques aigus.

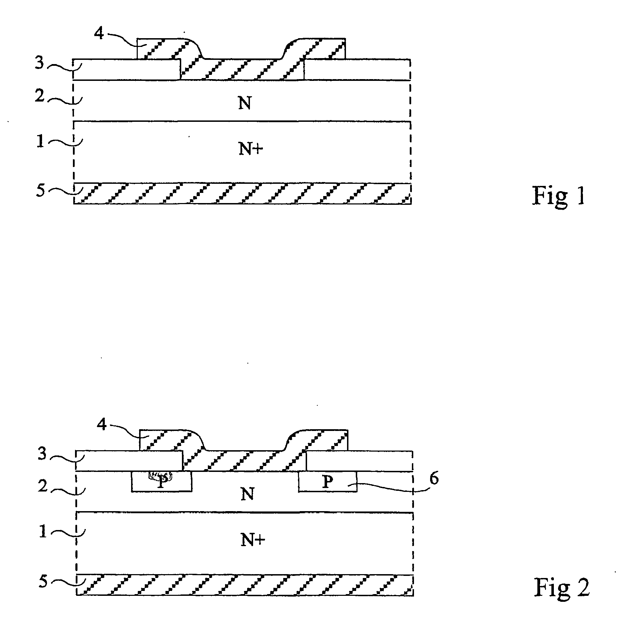

La structure élémentaire d'une diode Schottky est illustrée en figure 1. Cette diode est constituée à partir d'un substrat 1 de type N fortement dopé sur lequel est formée une couche épitaxiée 2 de type N convenablement dopée pour avoir le seuil Schottky souhaité. Sur cette couche épitaxiée N est déposé de l'oxyde de silicium 3 délimitant une fenêtre dans laquelle on veut établir le contact de Schottky au moyen d'une métallisation appropriée 4. La face arrière du composant est revêtue d'une métallisation 5.

Une telle structure présente une très mauvaise tenue en tension. En effet, les équipotentielles tendent à se recourber pour remonter vers la surface à la périphérie de la zone de contact et il en résulte, notamment dans les zones de courbure des équipotentielles de très fortes valeurs du champ qui limitent la tenue en tension en inverse possible. Pour éviter cet inconvénient, on utilise classiquement, pour des composants à base de silicium, la structure représentée en figure 2 dans laquelle un anneau périphérique 6 de type P est formé par implantation-diffusion à la périphérie de la zone active de la diode Schottky. Il en résulte que les équipotentielles doivent passer en volume sous les régions P et présentent donc une courbure moins marquée. La tenue en tension de la diode en est considérablement améliorée. A titre d'exemple avec du silicium d'un niveau de dopage de 10¹⁶ at./cm³, on aura une tenue en tension de l'ordre de 10 V sans anneau de garde et de l'ordre de 50 V avec anneau de garde.

Toutefois, comme on l'a indiqué précédemment, la réalisation d'un tel anneau de garde de type P n'est pas réalisable de façon simple par implantation/diffusion dans une structure réalisée sur un substrat de carbure de silicium. Dans ce cas, la structure simple illustrée en figure 1 n'est pas non plus souhaitable pour les mêmes raisons que dans le cas d'un substrat de silicium.

EP0380340 décrit la fabrication d'une diode Schottky en SiC. La réalisation de l'anneau de garde périphérique est effectuée par implantation d'aluminium ou de bore à haute température.

Ainsi, la présente invention vise à prévoir un procédé de fabrication de diode Schottky de tenue en tension relativement élevée qui puisse être mis en oeuvre simplement quand le semiconducteur est du carbure de silicium.

Pour atteindre ces objets, la présente invention prévoit un procédé de fabrication d'une diode Schottky verticale sur un substrat de carbure de silicium fortement dopé de type N, comprenant les étapes consistant à former sur le substrat une couche épitaxiée faiblement dopée de type N ; creuser dans la couche épitaxiée une tranchée périphérique à la zone active de la diode ; former une couche épitaxiée dopée de type P d'une épaisseur suffisante pour remplir la tranchée ; procéder à une opération de planarisation pour qu'il demeure seulement une couronne de la couche épitaxiée de type P dans la tranchée ; former sur la périphérie externe du composant une couche isolante recouvrant partiellement ladite couronne ; et déposer un métal formant une barrière Schottky avec la couche épitaxiée de type N.

Selon un mode de réalisation de la présente invention, ce procédé comprend en outre les étapes consistant à former en même temps que la tranchée périphérique, des rainures centrales qui sont remplies de portions de la couche épitaxiée de type P, afin de former une diode de type Schottky-bipolaire.

Selon un mode de réalisation de la présente invention, la couche épitaxiée de type N a une épaisseur de l'ordre de quelques *µ*m et un niveau de dopage de l'ordre de 10¹⁶ atomes/cm³, et la couche épitaxiée de type P a un niveau de dopage de l'ordre de 10¹⁶ atomes/cm³ et est formée dans une tranchée d'une profondeur de l'ordre du *µ*m.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe simplifiée d'une diode Schottky élémentaire ;
la figure 2 est une vue en coupe simplifiée d'une diode Schottky classique sur substrat de silicium ;
les figures 3A à 3C illustrent des étapes successives de formation d'une zone dopée dans un substrat de carbure de silicium ;
la figure 4 est une vue en coupe schématique d'une diode Schottky sur substrat de carbure de silicium ; et
la figure 5 représente un exemple de diode Schottky-bipolaire selon la présente invention.

Conformément à l'usage dans le domaine de la représentation des semiconducteurs, dans les diverses figures les diverses couches ne sont pas tracées à l'échelle, ni dans leurs dimensions horizontales, ni dans leurs dimensions verticales.

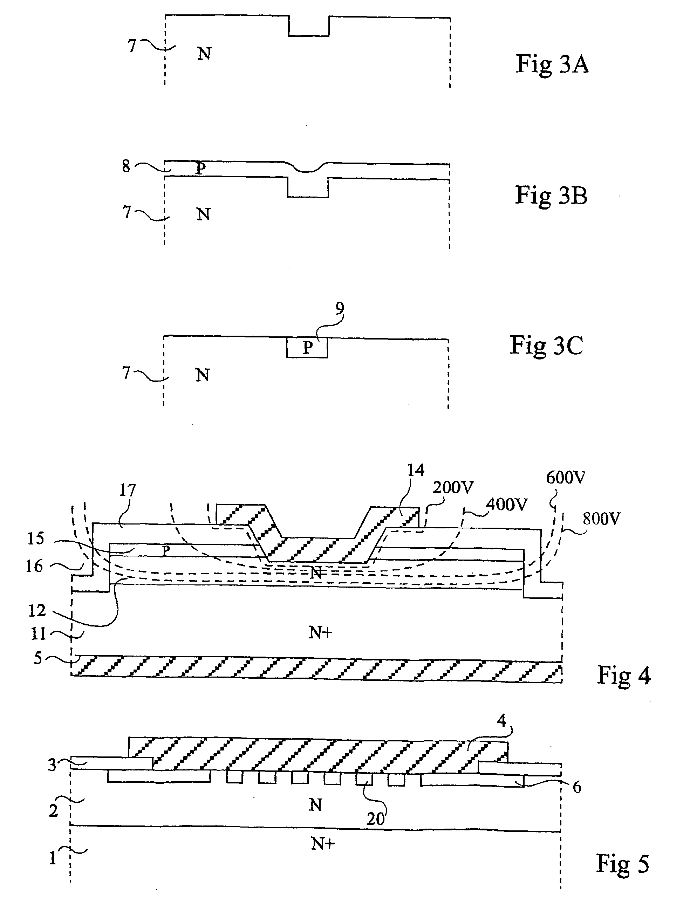

Comme l'illustrent les figures 3A à 3C, la présente invention prévoit une succession d'étapes permettant la formation d'une zone dopée dans un substrat de carbure de silicium sans qu'il soit nécessaire de recourir à des températures extrêmement élevées.

A l'étape de la figure 3A, on a formé un évidement dans un substrat de carbure de silicium 7. Cet évidement a des dimensions qui correspondent à celles de la zone dopée que l'on veut former et est formé par tout procédé adapté de photolithogravure. Le substrat 7 est un substrat massif ou une couche épitaxiée formée sur un support.

A l'étape de la figure 3B, on a formé une couche épitaxiée 8 dopée du type de conductivité désiré, par exemple de type opposé à celui du substrat. On pourra former une couche de type P sur un substrat de type N.

A l'étape de la figure 3C, on a procédé à une opération de planarisation pour qu'il demeure une portion 9 de la couche épitaxiée dans la tranchée. On a alors obtenu le résultat recherché.

Dans une tentative antérieure pour réaliser une diode Schottky à tenue en tension élevée à partir d'une plaquette de carbure de silicium, la demanderesse a proposé dans la demande de brevet français FR 2 803 103 la structure illustrée en figure 4.

La structure de la figure 4 est formée à partir d'une plaquette de carbure de silicium 11 fortement dopée de type N. Sur la plaquette 11 est formée une couche mince épitaxiée 12 de type N plus faiblement dopée. Pour une tenue en tension recherchée de l'ordre de 600 à 1000 V, cette couche épitaxiée a une épaisseur de l'ordre de 3 à 6 *µ*m. Le contact Schottky est formé entre cette couche 12 et une métallisation 14, par exemple un siliciure de platine, de titane ou de nickel ou autre. La face arrière de la plaquette 11 est revêtue d'une métallisation 5 correspondant à la cathode de la diode.

Cette structure est réalisée en procédant aux étapes suivantes :
formation d'une couche mince épitaxiée 15 de carbure de silicium dopée de type P, le dopant étant par exemple de l'aluminium,
formation d'une tranchée périphérique 16 ayant sensiblement la profondeur de la somme des épaisseurs des couches épitaxiées 12 et 15,
dépôt d'une couche d'un isolant de protection 17, par exemple de l'oxyde de silicium, et
formation d'une ouverture centrale dans laquelle est formée la couche de métal Schottky 14 qui est donc en contact avec la couche N 12 et qui polarise la couche P 15.

La distance entre la périphérie du contact Schottky et la tranchée est de l'ordre de 30 à 60 µm, par exemple de 40 µm.

Le dopage de la région 15 de type P est choisi pour que, quand une tension voisine de la tension inverse maximum que doit supporter la diode est appliquée à celle-ci, les équipotentielles au lieu de remonter toutes vers la surface s'étendent au moins partiellement jusqu'à la tranchée 16. Pour une diode pouvant supporter 800 à 1000 V, on a représenté quatre équipotentielles correspondant à quatre valeurs également réparties du potentiel, par exemple des valeurs proches de 200, 400, 600 et 800 V. On notera que l'équipotentielle correspondant sensiblement à 600 V atteint la tranchée.

La structure de la figure 4 nécessite un ajustement précis des dimensions et des paramètres de dopage ainsi qu'une bonne qualité de l'isolant recouvrant les parois de la tranchée.

En conséquence, les inventeurs ont recherché un moyen de réaliser une diode Schottky à tenue en tension élevée qui, comme la structure de la figure 4, puisse être réalisée sur carbure de silicium mais qui soit plus simple à réaliser.

Pour atteindre cet objet, les inventeurs ont réexaminé la structure réalisée classiquement sur substrat de silicium représentée en figure 2 et, au lieu de chercher à modifier cette structure, proposent pour obtenir cette structure d'utiliser le procédé décrit en relation avec les figures 3A à 3C.

Ainsi, pour fabriquer la structure de la figure 2 sur un substrat de carbure de silicium, les inventeurs proposent de partir d'un substrat de carbure de silicium 1 fortement dopé de type N⁺ sur lequel est formée une couche épitaxiée de carbure de silicium 2 faiblement dopée de type N. Le dopant N est par exemple de l'azote.

Selon l'invention, dans le substrat 2, on réalise une tranchée périphérique entourant la zone active de la diode puis on dépose par épitaxie une couche de carbure de silicium dopée de type P. Le dopant P est par exemple de l'aluminium. Après ce dépôt, on réalise une planarisation pour qu'il ne demeure que la région 6 de type P en forme de couronne se trouvant dans la tranchée préalablement formée. Cette planarisation est par exemple réalisée par gravure mécano-chimique. Après quoi, on dépose et on ouvre une couche isolante 4 puis on forme la métallisation 4 pour obtenir la structure représentée en figure 2.

Ainsi, contrairement à l'état de la technique sur silicium dans lequel la couronne 6 de type P résulte d'une implantation-diffusion, selon la présente invention, la couronne 6 de type P résulte d'une épitaxie. Le fait que cette région de type P résulte d'une épitaxie et non pas d'une implantation-diffusion, entraîne que cette région de type P a un niveau de dopage homogène, alors que, quand une structure résulte d'une implantation-diffusion, elle comprend des inégalités de niveau de dopage. Par exemple, si l'implantation est une implantation superficielle, le dopage en surface est plus élevé que le dopage au niveau de la jonction.

Les inventeurs ont réalisé des simulations sur la structure obtenue en utilisant des procédés de simulation connus en eux-mêmes, et en faisant usage du programme de simulation connu sous l'appellation ISE-DESSIS, commercialisé par la Société ISE. Ces simulations ont montré que, pour une structure du type de celle de la figure 2, avec une couche épitaxiée de type N d'une épaisseur de 12 *µ*m et d'un niveau de dopage de 8.10¹⁵ at./cm³,
- dans le cas d'une structure avec une couronne de type P obtenue par implantation-diffusion d'une profondeur de 0, 7 µm et d'un niveau de dopage de 2.10¹⁷ at./cm³, on obtenait une tenue en tension inverse de 1205 volts ;
- dans le cas d'une tranchée d'une profondeur de 1,5 µm remplie d'une couche épitaxiée de type P du même niveau de dopage de 2.10¹⁷ at./cm³, on obtenait une tenue en tension inverse de 1223 volts ; et
- dans le cas d'une tranchée d'une profondeur de 1,5 µm remplie d'une couche épitaxiée de type P d'un niveau de dopage de 5.10¹⁶ at./cm³, on obtenait une tenue en tension inverse de 1415 volts.

On pourra par exemple utiliser une structure dans laquelle la couche épitaxiée de type N a une épaisseur de l'ordre de quelques *µ*m et un niveau de dopage de l'ordre de 10¹⁶ atomes/cm³, et la couche épitaxiée de type P a un niveau de dopage de l'ordre de 10¹⁶ atomes/cm³ et est formée dans une tranchée d'une profondeur de l'ordre du *µ*m.

De plus, les simulations montrent que, quand on pousse une structure selon la présente invention jusqu'au claquage, le claquage survient sensiblement au milieu de la couronne de type P. Ainsi, il s'agit d'un claquage en volume et non pas d'un claquage en surface et il est bien connu que l'on arrive alors au maximum théorique possible pour la tension de claquage.

On a également comparé la structure selon la présente invention à la structure illustrée en figure 4 et l'on a constaté que, là aussi, la tenue en tension était meilleure dans des conditions similaires, c'est-à-dire pour un même niveau de dopage de la couche épitaxiée de type N dans le cas de la présente invention par rapport au cas de la figure 4.

En plus de cet avantage de simplicité de réalisation et de meilleure tenue en tension de la structure de la présente invention par rapport à la structure de l'art antérieur, on notera qu'un autre avantage de la présente invention est qu'elle se prête à la réalisation de diodes d'un type particulier, connu sous l'appellation diodes Schottky/bipolaire. Dans ces diodes, la métallisation est par endroits en contact avec la couche épitaxiée de type N et forme avec celle-ci un contact Schottky, et par endroits en contact avec des régions de type P et forme avec celles-ci un contact ohmique. La distance entre les régions N et P est calculée d'une façon connue dans la technique pour optimiser la tenue en tension et la rapidité de la diode.

Une telle diode est représentée en figure 5. Elle comprend la même structure et la même région périphérique 6 que la diode de la figure 2. Toutefois, elle comprend en outre sous le contact 4, des régions 20 dopées de type P régulièrement espacées. Ces régions ont par exemple des formes annulaires concentriques ou en bandes parallèles. Selon la présente invention, ces régions 20 résultent de la formation de tranchées en même temps que la formation de la tranchée périphérique. Ainsi, lors de dépôt d'une couche épitaxiale de type P, la couche épitaxiale de type P remplit les tranchées centrales en même temps que la tranchée périphérique. Après un polissage mécano-chimique ou autre étape de planarisation, on obtient simplement la structure de la figure 5 dans laquelle la tranchée périphérique est remplie d'une portion de couche épitaxiée 6 et les tranchées centrales sont remplies de portions 20 de la même couche épitaxiée.

Bien entendu, la présente invention est susceptible, dans le cadre des revendications, de diverses variantes et modifications qui apparaîtront à l'homme de l'art, en particulier en ce qui concerne les dimensions des diverses couches, tant verticalement qu'horizontalement.

## Revendications

1. Procédé de fabrication d'une diode Schottky verticale sur un substrat (1) de carbure de silicium fortement dopé de type N, comprenant les étapes suivantes :
former sur le substrat (1) une couche épitaxiée (2) faiblement dopée de type N ;
creuser dans la couche épitaxiée (2) une tranchée périphérique à la zone active de la diode ;
former une couche épitaxiée dopée de type P d'une épaisseur suffisante pour remplir la tranchée ;
procéder à une opération de planarisation pour qu'il demeure seulement une couronne (6) de la couche épitaxiée de type P dans la tranchée ;
former sur la périphérie externe du composant une couche isolante (3) recouvrant partiellement ladite couronne ; et
déposer un métal (4) formant une barrière Schottky avec la couche épitaxiée de type N.

2. Procédé selon la revendication 1, **caractérisé en ce qu'**il comprend en outre les étapes consistant à former en même temps que la tranchée périphérique, des rainures centrales qui sont remplies de portions (20) de la couche épitaxiée de type P, afin de former une diode de type Schottky-bipolaire.

3. Procédé selon la revendication 1, **caractérisé en ce que** la couche épitaxiée de type N a une épaisseur de l'ordre de quelques µm et un niveau de dopage de l'ordre de 10¹⁶ atomes/cm³, et la couche épitaxiée de type P a un niveau de dopage de l'ordre de 10¹⁶ atomes/cm³ et est formée dans une tranchée d'une profondeur de l'ordre du µm.

## Patentansprüche

1. Verfahren zum Herstellen einer vertikalen Schottky-Diode auf einem stark dotierten N-Typ-Silizium-Carbid-Substrat (1), wobei das Verfahren die folgenden Schritte aufweist:
Ausbilden einer leicht dotierten N-Typ-Epitaxialschicht (2) auf dem Substrat (1);
Ausgraben eines Grabens in der Epitaxialschicht (2) und zwar umfangsmäßig bezüglich des aktiven Diodenbereichs;
Ausbilden einer P-Typ-dotierten Epitaxialschicht mit einer ausreichenden Dicke zum Ausfüllen des Grabens;
Planarisieren, sodass nur ein Ring (6) der P-Typ-Epitaxialschicht in dem Graben verbleibt;
Ausbilden am äußeren Umfang des Bauteils einer Isolierschicht (3), die teilweise den Ring abdeckt; und
Abscheiden eines Metalls (4), das eine Schottky-Barriere bildet mit der N-Typ-Epitaxialschicht.

2. Verfahren nach Anspruch 1 **dadurch gekennzeichnet, dass** es ferner die Schritte der Ausbildung von Mittelnuten gleichzeitig mit dem Umfangsgraben aufweist, die mit Teilen (20) der P-Typ-Epitaxialschicht gefüllt werden, um eine Diode des bipolaren Schottky-Typs zu bilden.

3. Verfahren nach Anspruch 1 **dadurch gekennzeichnet, dass** die N-Typ-Epitaxialschicht eine Dicke in der Größenordnung von einigen µm und ein Dotierniveau in der Größenordnung von 10¹⁶ Atomen/cm³ besitzt, und das die P-Typ-Epitaxialschicht ein Dotierniveau in der Größenordnung von 10¹⁶ Atomen/cm³ besitzt und in einem Graben mit einer Tiefe in der Größenordnung von ein µm ausgebildet ist.

## Claims

1. A method for manufacturing a vertical Schottky diode on a heavily-doped N-type silicon carbide substrate (1), including the steps of:
forming on the substrate (1) a lightly-doped N-type epitaxial layer (2);
digging in the epitaxial layer (2) a trench peripheral to the active diode area;
forming a P-type doped epitaxial layer having a sufficient thickness for filling the trench;
planarizing so that a ring (6) of the P-type epitaxial layer remains only in the trench;
forming on the external periphery of the component an insulating layer (3) partially covering said ring; and
depositing a metal (4) forming a Schottky barrier with the N-type epitaxial layer.

2. The method of claim 1, **characterized in that** it further includes the steps of forming at the same time as the peripheral trench central grooves which are filled with portions (20) of the P-type epitaxial layer, to form a diode of Schottky-bipolar type.

3. The method of claim 1, **characterized in that** the N-type epitaxial layer has a thickness on the order of a few µm and a doping level on the order of 10¹⁶ atoms/cm³, and the P-type epitaxial layer has a doping level on the order of 10¹⁶ atoms/cm³ and is formed in a trench having a depth on the order of one µm.
